# FASCICULE DE BREVET EUROPEEN

(11) **EP 3 292 744 B1**
(45) Date de publication et mention de la délivrance du brevet: **05.06.2019**
(21) Numéro de dépôt: 16723414.5
(22) Date de dépôt: 15.04.2016
(51) Int. Cl.: H05K 7/14, H05K 5/02

(54) **SYSTÈME DE PROTECTION POUR CONNECTEUR ÉLECTRIQUE D'UN MODULE ÉLECTRONIQUE DE PUISSANCE**
SYSTEM ZUM SCHUTZ EINES ELEKTRISCHEN STECKERS EINES ELEKTRONISCHEN LEISTUNGSMODULS
SYSTEM FOR PROTECTING AN ELECTRICAL CONNECTOR OF AN ELECTRONIC POWER MODULE

(30) Priorité: 05.05.2015 FR 1553996
(43) Date de publication de la demande: 14.03.2018
(73) Titulaire: Renault S.A.S., 92100 Boulogne-Billancourt (FR)
(72) Inventeur: GAGNEPAIN, Yacine, 78320 Mesnil-Saint-Denis (FR); GATEAU, Jean-Luc, 78990 Elancourt (FR)
(86) Numéro de dépôt international: PCT/FR2016/050882
(87) Numéro de publication internationale: WO 2016/177949

(56) Documents cités:
- FR-A1- 2 983 360
- JP-A- 2012 126 152
- JP-A- 2013 066 327
- JP-A- 2013 121 779
- US-A1- 2006 211 287

## Description

La présente invention se rapporte de manière générale au domaine de la mécanique et plus précisément à un dispositif de protection contre les chocs d'un connecteur électrique destiné à alimenter en haute tension un groupe motopropulseur électrique.

En effet les véhicules automobiles classiques c'est-à-dire thermiques disposent de divers dispositifs de sécurité permettant de limiter les risques pour le conducteur et ses passagers en cas de chocs. Les véhicules électriques bénéficient des mêmes dispositifs mais nécessitent également d'autres mécanismes de protection, notamment contre les risques électriques en cas de chocs. Les connecteurs des lignes d'alimentation haute tension du groupe motopropulseur électrique d'un tel véhicule doivent notamment être protégés.

Le brevet français FR2983360 propose un dispositif de protection permettant de protéger un connecteur électrique d'un module d'électronique de puissance d'un système de traction d'un véhicule électrique, contre un choc frontal sur celui-ci. Ce dispositif présente néanmoins un encombrement important dans le compartiment moteur du véhicule, et son montage est de ce fait peu rapide. De plus il doit comporter un nombre important de fixations par vis pour ne pas s'affaisser lors d'un choc frontal, notamment au niveau de l'appui d'une face de protection du dispositif sur un arceau formant saillie du carter du module d'électronique de puissance. Ces fixations rendent le montage du dispositif de protection difficile vu l'encombrement du compartiment moteur, et donc coûteux en temps.

Un des buts de l'invention est de remédier à au moins une partie des inconvénients de la technique antérieure en fournissant un système de protection pour module d'électronique de puissance, qui se monte facilement et permette de protéger efficacement les connecteurs haute tension du module d'électronique de puissance.

A cette fin, l'invention propose un système de protection pour connecteur électrique d'un module d'électronique de puissance inséré dans un carter, ledit connecteur faisant saillie sur une des faces dudit carter et étant apte à connecter une ligne d'alimentation électrique audit module, caractérisé en ce que ledit système comporte :
- une pièce frontale en U apte à englober ledit connecteur dans un volume s'étendant entre ladite face dudit carter et un plan parallèle à ladite face dudit carter passant par la base de ladite pièce frontale en U, ladite pièce frontale comportant deux embouts aptes à prendre appui sur ledit carter lorsqu'une force est exercée en direction de ladite face dudit carter,
- une pièce de maintien de ladite pièce frontale en U comportant au moins un moyen de fixation audit carter,
- et deux zones anti-glissement sur ladite face dudit carter, aptes à coopérer avec lesdits deux embouts.

Grâce à l'invention, on protège un connecteur haute tension avec un système peu encombrant, ne nécessitant que peu de fixations donc facilitant son montage. En effet les zones anti-glissement permettent d'économiser des fixations. De plus l'utilisation d'une pièce frontale en U permet d'économiser de la matière dans au moins une direction relative au connecteur à protéger.

Selon une caractéristique avantageuse du système de protection selon l'invention, ladite pièce frontale en U est un tube de diamètre de l'ordre de 20mm (millimètres).

Cette structure tubulaire de la pièce frontale se déforme en fournissant une protection efficace en cas de choc frontal.

Selon une autre caractéristique avantageuse du système de protection selon l'invention, ledit au moins un moyen de fixation audit carter comporte deux vis ou un trottoir, aptes à coopérer avec un ou plusieurs évidements correspondants dans ledit carter. Ainsi la pièce de maintien est fixée simplement au carter du module électronique de puissance, assurant un montage rapide.

Avantageusement, ladite pièce frontale ne comporte pas de moyen de fixation sur ledit carter. En effet les zones anti-glissement sur le carter permettent de s'affranchir notamment de moyens de fixation vissés sur la pièce frontale.

Avantageusement encore, ladite pièce de maintien comporte une ou plusieurs pattes soudées à ladite pièce frontale. Ainsi les deux pièces étant d'un seul tenant, leur montage est facilité.

Selon une autre caractéristique avantageuse du système de protection selon l'invention, au moins un desdits deux embouts présente une surface plane coopérant avec une desdites zones anti-glissement, ladite zone anti-glissement présentant une surface plane sur ladite face dudit carter, ainsi qu'une équerre apte à empêcher ledit embout de glisser dans une direction orthogonale à ladite force. Ce système anti-glissement garantit un bon maintien du protecteur lors d'un choc frontal sans élément de fixation ajouté.

Alternativement, au moins un desdits deux embouts présente une surface striée coopérant avec une surface striée d'au moins une desdites zones anti-glissement, l'emboîtement desdites surfaces striées étant apte à empêcher ledit embout de glisser dans une direction orthogonale à ladite force. Cette alternative de réalisation assure également un bon maintien du protecteur mais nécessite une certaine précision de réalisation afin que les surfaces striées puissent s'emboîter.

L'invention concerne également un groupe motopropulseur électrique pour véhicule électrique, comportant au moins un module d'électronique de puissance protégé dans un carter, ledit carter comportant une face supportant un connecteur faisant saillie sur ladite face et apte à connecter une ligne d'alimentation électrique audit module, caractérisé en ce que ledit connecteur est protégé par le système de protection selon l'invention, et en ce que lesdites deux zones anti-glissement forment deux pièces moulées solidairement avec ledit carter.

Le groupe motopropulseur électrique selon l'invention présente des avantages analogues à ceux du système de protection selon l'invention.

D'autres caractéristiques et avantages apparaîtront à la lecture d'un mode de réalisation préféré décrit en référence aux figures dans lesquelles :
- la figure 1 représente un mode de réalisation préféré du système de protection selon l'invention,
- la figure 2 représente isolément des pièces du système de protection selon l'invention, dans ce mode de réalisation préféré,
- la figure 3 représente une zone anti-glissement du système de protection selon l'invention, dans ce mode de réalisation préféré,
- la figure 4 représente une force exercée sur le système de protection selon l'invention, lors d'un choc frontal, dans ce mode de réalisation préféré,
- la figure 5 représente une vue de côté du système de protection selon l'invention, dans ce mode de réalisation préféré,
- et la figure 6 représente une vue de côté du système de protection selon l'invention, selon une variante de ce mode de réalisation préféré.

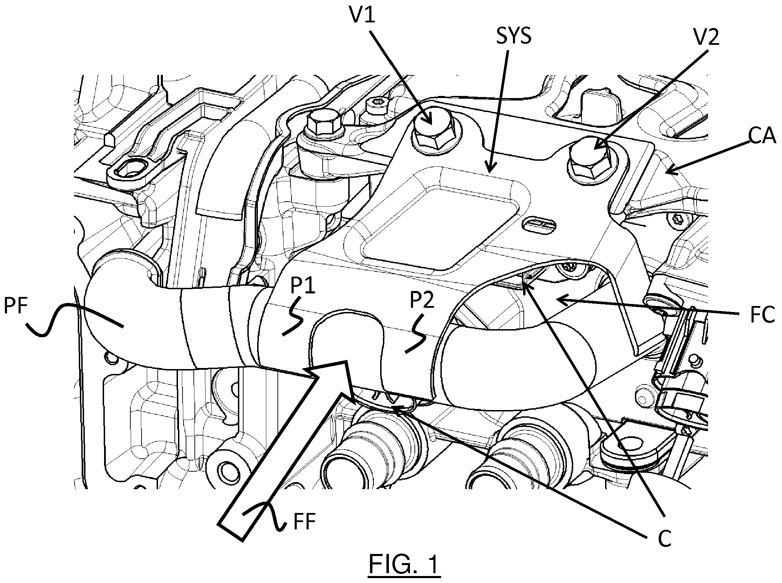

Selon un mode de réalisation préféré de l'invention représenté à la **figure 1****,** un système SYS de protection de connecteurs électriques C est monté sur la face FC d'un carter CA d'un module d'électronique de puissance d'un groupe motopropulseur électrique d'un véhicule électrique.

La face FC du carter CA est disposée frontalement dans le compartiment moteur avant du véhicule. Les connecteurs électriques C haute tension sont donc particulièrement sensibles à un choc frontal en cas d'accident, sans protection spécifique.

Le système SYS de protection comporte une pièce frontale PF sensiblement en forme de U, qui permet de protéger les connecteurs électriques C se situant, dans une direction longitudinale du véhicule, entre la face FC du carter CA et la pièce frontale PF lorsqu'une force FF est exercée en direction de la face FC du carter CA. En effet lorsqu'une telle force FF est exercée sur la pièce frontale PF, celle-ci résiste en prenant appui par ses embouts sur la face FC du carter CA. Pour cela la pièce frontale en U est apte à englober les connecteurs dans un volume s'étendant longitudinalement au véhicule entre la face FC du carter CA et un plan parallèle à la face FC comportant la base de la pièce frontale en U. Les connecteurs les plus sensibles sont disposés verticalement sensiblement au niveau des pattes de la pièce frontale en U. Par sensiblement on entend à moins de 10% près par rapport à la hauteur verticale du carter CA.

La pièce frontale PF est par ailleurs maintenue dans cette position et fixée au carter CA par une pièce de maintien PM vissée par deux vis V1 et V2 sur le dessus du carter CA. En variante, la pièce de maintien PM est accrochée sur le carter CA par un trottoir s'emboîtant dans un évidement correspondant sur le dessus du carter CA. D'autres variantes de réalisation de la pièce de maintien sont bien sûr possibles.

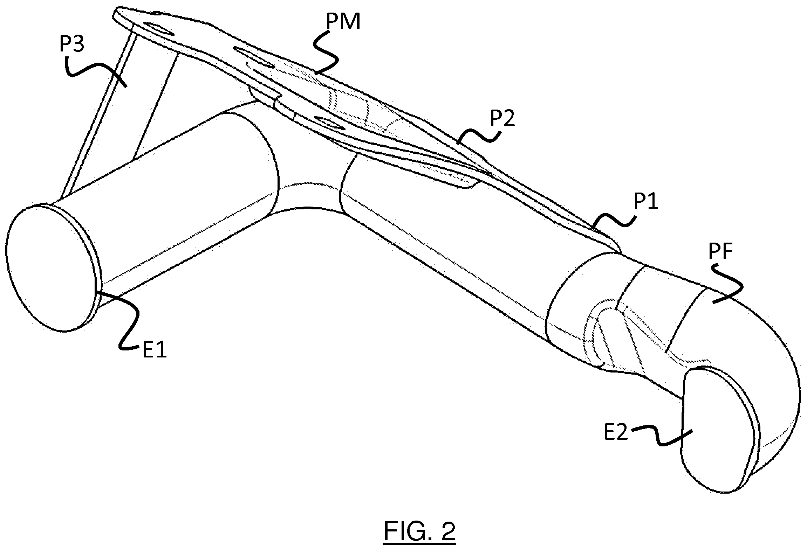

De préférence, comme visible sur la **figure 2****,** la pièce de maintien PM est soudée à la pièce frontale PF au niveau de pattes P1, P2 et P3 de fixation. Ainsi on minimise les fixations à installer pour un opérateur qui doit monter le système de protection dans le véhicule. Les pièces de maintien PM et frontale PF sont de préférence chacune réalisées en acier.

Dans ce mode de réalisation de l'invention, la pièce frontale PF est tubulaire, de diamètre environ 20mm. Cette forme tubulaire est écrasée juste avant le coude de la pièce frontale PF comportant l'embout E2, dans ce mode de réalisation de l'invention, pour une raison architecturale. Cette forme tubulaire n'est donc pas forcément régulière. Son diamètre est variable selon l'effort d'un choc frontal éventuel à contrer et selon le type de véhicule. De même dans ce mode de réalisation de l'invention, la forme en U de la pièce frontale n'est pas régulière, une des pattes du U étant plus petite que l'autre, pour s'adapter aux irrégularités de la face FC du carter qui n'est pas complètement plane. En variante, d'autres formes de pièce frontale en U irrégulières sont utilisables, pourvu qu'elles absorbent un choc frontal sans venir écraser les connecteurs qu'elles protègent. Ainsi il est possible d'utiliser une pièce frontale en U de section quelconque (creuse ou pleine).

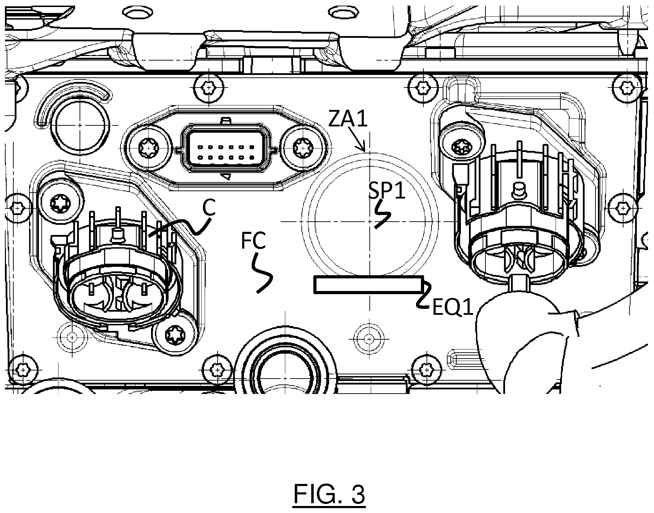

Les embouts E1 et E2 sont préférentiellement plats, aptes à prendre appui sur des zones anti-glissement correspondantes sur la face FC du carter CA. On appelle dans cette demande zone anti-glissement une zone comportant un moyen apte à empêcher l'embout E1 ou E2 de glisser sur la face FC du carter CA. La **figure 3** montre une zone anti-glissement ZA1 sur la face FC du carter CA, apte à accueillir l'embout E1 de la pièce frontale PF. Cette zone anti-glissement comporte une surface d'appui plane SP1 pour l'embout E1, et une équerre EQ1 sous cette zone d'appui plane. En variante cette zone anti-glissement comporte un évidemment apte à recevoir un ergot présent sur l'embout correspondant de la pièce frontale, qui n'est donc pas complètement plan dans cette variante de réalisation.

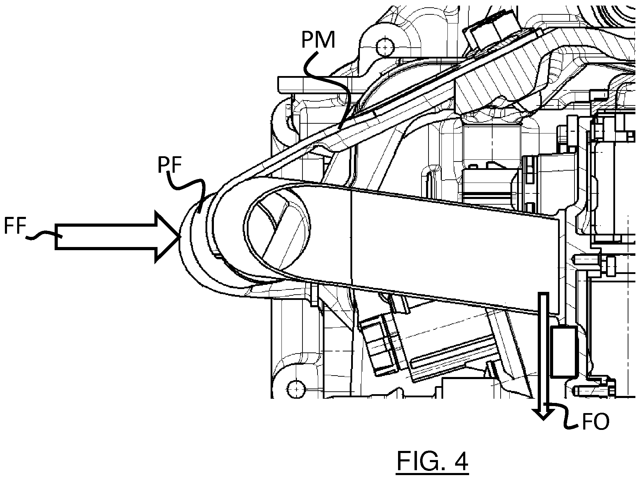

Ainsi lorsqu'une force FF est exercée en direction de la face FC du carter CA, comme visible sur la **figure 4****,** la force de glissement FO à laquelle est soumise l'embout E1 est contrée par l'équerre EQ1. Il est à noter que dans ce mode de réalisation, cette force de glissement FO est dirigée vers le bas du véhicule, la pièce frontale PF étant dans un plan sensiblement orthogonal à la face FC du carter et obliquant légèrement vers le bas du véhicule dans la direction de la force FF. Dans d'autres modes de réalisation, les zones anti-glissement sont adaptées à la disposition de la pièce frontale PF. Par exemple si en variante la pièce frontale oblique légèrement vers le haut du véhicule dans la direction de la force FF, alors la zone anti-glissement présente une équerre disposée sur le dessus de sa surface d'appui apte à accueillir l'embout correspondant de la pièce frontale.

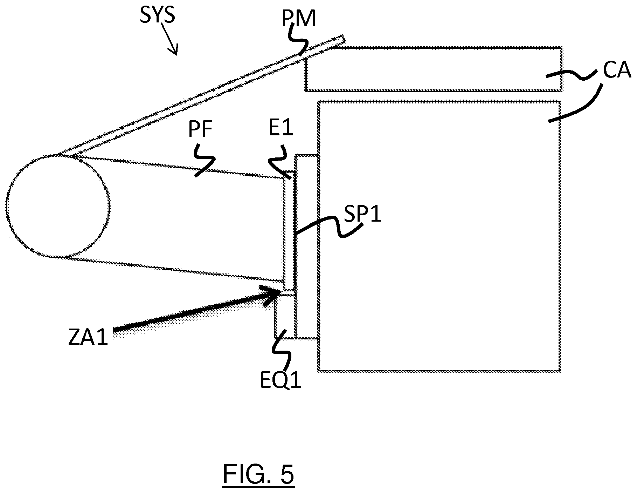

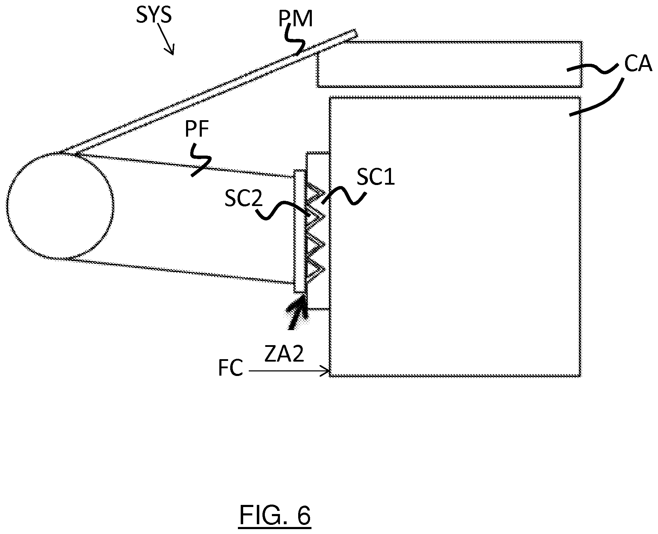

L'équerre EQ1 est plus visible sur la **figure 5** montrant de côté le système de protection SYS monté sur le carter CA. La **figure 6** montre une variante de réalisation d'une zone anti-glissement ZA2, comportant une surface striée SC1 comportant des rainures horizontales. Un embout correspondant de la pièce frontale PF apte à prendre appui sur cette zone anti-glissement ZA2 comporte également une surface striée SC2. La surface striée SC2 comporte des rainures horizontales aptes à s'emboîter dans les sillons formés entre les rainures horizontales de la surface striée SC1. Ainsi lorsqu'une force FF est exercée en direction de la face FC du carter CA, l'embout à la surface striée SC2 est retenu contre une force de glissement vers le bas du véhicule, par les rainures horizontales de la surface anti-glissement ZA2 sur lesquelles elle prend appui.

## Revendications

1. Système (SYS) de protection pour connecteur électrique (C) d'un module d'électronique de puissance inséré dans un carter (CA), ledit connecteur (C) faisant saillie sur une des faces (FC) dudit carter(CA) et étant apte à connecter une ligne d'alimentation électrique audit module, **caractérisé en ce que** ledit système (SYS) comporte :
- une pièce frontale (PF) en U apte à englober ledit connecteur (C) dans un volume s'étendant entre ladite face (FC) dudit carter (CA) et un plan parallèle à ladite face (FC) dudit carter (CA) passant par la base de ladite pièce frontale (PF) en U, ladite pièce frontale (PF) comportant deux embouts (E1, E2) aptes à prendre appui sur ledit carter (CA) lorsqu'une force (FF) est exercée en direction de ladite face (FC) dudit carter (CA),
- une pièce de maintien (PM) de ladite pièce frontale (PF) en U comportant au moins un moyen de fixation audit carter (CA),
- et deux zones anti-glissement (ZA1) sur ladite face (FC) dudit carter (CA), aptes à coopérer avec lesdits deux embouts (E1, E2).

2. Système (SYS) de protection selon la revendication 1, dans lequel ladite pièce frontale (PF) en U est un tube de diamètre de l'ordre de 20mm.

3. Système (SYS) de protection selon la revendication 1 ou 2, dans lequel ledit au moins un moyen de fixation audit carter (CA) comporte deux vis (V1, V2) ou un trottoir, aptes à coopérer avec un ou plusieurs évidements correspondants dans ledit carter (CA).

4. Système (SYS) de protection selon l'une quelconque des revendications 1 à 3, dans lequel ladite pièce frontale (PF) ne comporte pas de moyen de fixation sur ledit carter (CA).

5. Système (SYS) de protection selon l'une quelconque des revendications 1 à 4, dans lequel ladite pièce de maintien (PM) comporte une ou plusieurs pattes (P1, P2, P3) soudées à ladite pièce frontale (PF).

6. Système (SYS) de protection selon l'une quelconque des revendications 1 à 5, dans lequel au moins un desdits deux embouts (E1, E2) présente une surface plane coopérant avec une desdites zones anti-glissement (ZA1), ladite zone anti-glissement (ZA1) présentant une surface plane (SP1) sur ladite face (FC) dudit carter (CA), ainsi qu'une équerre (EQ1) apte à empêcher ledit embout (E1) de glisser dans une direction orthogonale à ladite force (FF).

7. Système (SYS) de protection selon l'une quelconque des revendications 1 à 5, dans lequel au moins un desdits deux embouts (E2) présente une surface striée (SC2) coopérant avec une surface striée (SC1) d'au moins une desdites zones anti-glissement (ZA2), l'emboîtement desdites surfaces striées (SC1, SC2) étant apte à empêcher ledit embout (E2) de glisser dans une direction orthogonale à ladite force (FF).

8. Groupe motopropulseur électrique pour véhicule électrique, comportant au moins un module d'électronique de puissance protégé dans un carter (CA), ledit carter (CA) comportant une face (FC) supportant un connecteur (C) faisant saillie sur ladite face (FC) et apte à connecter une ligne d'alimentation électrique audit module, **caractérisé en ce que** ledit connecteur (C) est protégé par le système (SYS) de protection selon l'une quelconque des revendications 1 à 7, et **en ce que** lesdites deux zones anti-glissement (ZA1, ZA2) forment deux pièces moulées solidairement avec ledit carter (CA).

## Patentansprüche

1. Schutzsystem (SYS) für einen elektrischen Verbinder (C) eines elektronischen Leistungsmoduls, das in ein Gehäuse (CA) eingesetzt ist, wobei der Verbinder (C) auf einer der Flächen (FC) des Gehäuses (CA) vorsteht und dafür ausgelegt ist, eine elektrische Versorgungsleitung mit dem Modul zu verbinden, **dadurch gekennzeichnet, dass** das System (SYS) Folgendes umfasst:
- ein U-förmiges vorderes Teil (PF), das den Verbinder (C) in einem Volumen umgeben kann, das sich zwischen der Fläche (FC) des Gehäuses (CA) und einer Ebene parallel zu der Fläche (FC) des Gehäuses (CA), die durch die Basis des U-förmigen vorderen Teils (PF) verläuft, erstreckt, wobei das vordere Teil (PF) zwei Ansätze (E1, E2) aufweist, die sich auf dem Gehäuse (CA) abstützen können, wenn in Richtung der Fläche (FC) des Gehäuses (CA) eine Kraft (FF) ausgeübt wird,
- ein Halteteil (PM) für das U-förmige vordere Teil (PF), das wenigstens ein Mittel für die Befestigung an dem Gehäuse (CA) aufweist,
- und zwei Gleitverhinderungszonen (ZA1) an der Fläche (FC) des Gehäuses (CA), die mit den zwei Ansätzen (E1, E2) zusammenwirken können.

2. Schutzsystem (SYS) nach Anspruch 1, wobei das U-förmige vordere Teil (PF) ein Rohr mit einem Durchmesser in der Größenordnung von 20 mm ist.

3. Schutzsystem (SYS) nach Anspruch 1 oder 2, wobei das wenigstens eine Mittel für die Befestigung an dem Gehäuse (CA) zwei Schrauben (V1, V2) oder eine Bahn aufweist, die mit einer oder mehreren entsprechenden Aussparungen in dem Gehäuse (CA) zusammenwirken können.

4. Schutzsystem (SYS) nach einem der Ansprüche 1 bis 3, wobei das vordere Teil (PF) kein Mittel für die Befestigung an dem Gehäuse (CA) aufweist.

5. Schutzsystem (SYS) nach einem der Ansprüche 1 bis 4, wobei das Halteteil (PM) eine oder mehrere Laschen (P1, P2, P3), die an das vordere Teil (PF) geschweißt sind, aufweist.

6. Schutzsystem (SYS) nach einem der Ansprüche 1 bis 5, wobei wenigstens einer der zwei Ansätze (E1, E2) eine ebene Oberfläche aufweist, die mit einer der Gleitverhinderungszonen (ZA1) zusammenwirkt, wobei die Gleitverhinderungszone (ZA1) eine ebene Oberfläche (SP1) auf der Fläche (FC) des Gehäuses (CA) sowie eine Ecke (EQ1), die verhindern kann, dass der Ansatz (E1) in einer Richtung senkrecht zu der Kraft (FF) gleitet, aufweist.

7. Schutzsystem (SYS) nach einem der Ansprüche 1 bis 5, wobei wenigstens einer der zwei Ansätze (E2) eine geriefte Oberfläche (SC2) aufweist, die mit einer gerieften Oberfläche (SC1) wenigstens einer der Gleitverhinderungszonen (ZA2) zusammenwirkt, wobei das Ineinanderfügen der gerieften Oberflächen (SC1, SC2) verhindern kann, dass der Ansatz (E2) in einer Richtung senkrecht zu der Kraft (FF) gleitet.

8. Elektrische Triebwerksgruppe für Elektrofahrzeug, die wenigstens ein elektronisches Leistungsmodul umfasst, das in einem Gehäuse (CA) geschützt ist, wobei das Gehäuse (CA) eine Fläche (FC) aufweist, die einen Verbinder (C) trägt, der auf der Fläche (FC) vorsteht und eine elektrische Versorgungsleitung mit dem Modul verbinden kann, **dadurch gekennzeichnet, dass** der Verbinder (C) durch das Schutzsystem (SYS) nach einem der Ansprüche 1 bis 7 geschützt ist und dass die zwei Gleitverhinderungszonen (ZA1, ZA2) zwei mit dem Gehäuse (CA) fest vergossene Teile bilden.

## Claims

1. System (SYS) for protecting an electrical connector (C) of an electronic power module inserted into a housing (CA), said connector (C) protruding from one of the faces (FC) of said housing (CA) and being suitable for connecting an electric supply line to said module, **characterized in that** said system (SYS) includes:
- a U-shaped front part (PF) suitable for encompassing said connector (C) in a volume extending between said face (FC) of said housing (CA) and a plane parallel to said face (FC) of said housing (CA) passing through the base of said U-shaped front part (PF), said front part (PF) including two end pieces (E1, E2) suitable for bearing on said housing (CA) when a force (FF) is exerted towards said face (FC) of said housing (CA),
- a part (PM) for holding said U-shaped front part (PF) including at least one means for fixing to said housing (CA),
- and two non-slip zones (ZA1) on said face (FC) of said housing (CA), which are suitable for engaging said two end pieces (E1, E2).

2. Protection system (SYS) according to Claim 1, wherein said U-shaped front part (PF) is a tube with a diameter of approximately 20 mm.

3. Protection system (SYS) according to Claim 1 or 2, wherein said at least one means for fixing to said housing (CA) includes two screws (V1, V2) or a raised track, which are suitable for engaging one or more corresponding recesses in said housing (CA).

4. Protection system (SYS) according to any one of Claims 1 to 3, wherein said front part (PF) does not include a means for fixing on said housing (CA).

5. Protection system (SYS) according to any one of Claims 1 to 4, wherein said holding part (PM) includes one or more lugs (P1, P2, P3) welded to said front part (PF).

6. Protection system (SYS) according to any one of Claims 1 to 5, wherein at least one of said two end pieces (E1, E2) has a planar surface engaging one of said non-slip zones (ZA1), said non-slip zone (ZA1) having a planar surface (SP1) on said face (FC) of said housing (CA), as well as a bracket (EQ1) suitable for preventing said end piece (E1) from slipping in a direction orthogonal to said force (FF).

7. Protection system (SYS) according to any one of Claims 1 to 5, wherein at least one of said two end pieces (E2) has a corrugated surface (SC2) engaging a corrugated surface (SC1) of at least one of said non-slip zones (ZA2), the fitting together of said corrugated surfaces (SC1, SC2) being suitable for preventing said end piece (E2) from slipping in a direction orthogonal to said force (FF).

8. Electric power train for an electric vehicle, including at least one electronic power module protected in a housing (CA), said housing (CA) including a face (FC) supporting a connector (C) protruding from said face (FC) and suitable for connecting an electric supply line to said module, **characterized in that** said connector (C) is protected by the protection system (SYS) according to any one of Claims 1 to 7, and **in that** said two non-slip zones (ZA1, ZA2) form two parts integrally molded with said housing (CA).
